# EUROPEAN PATENT SPECIFICATION

(11) **EP 0 507 456 B1**
(45) Date of publication and mention of the grant of the patent: **18.12.1996**
(21) Application number: 92301937.6
(22) Date of filing: 06.03.1992
(51) Int. Cl.: H01L 31/0232, H01L 31/0216, H01L 27/146

(54) **Solid-state imaging device and method of manufacturing the same**
Festkörper-Bildaufnahme-Vorrichtung und deren Herstellungsmethode
Dispositif d'imagerie à l'état solide et sa méthode de fabrication

(30) Priority: 06.03.1991 JP 39989/91; 06.03.1991 JP 39990/91
(43) Date of publication of application: 07.10.1992
(60) Divisional application: 95200566.8
(73) Proprietor: Matsushita Electronics Corporation, Kadoma-shi, Osaka 571 (JP)
(72) Inventor: Nomura, Toru, Takatsuki-shi, Osaka 569 (JP)
(74) Representative: Crawford, Andrew Birkby

(56) References cited:
- EP-A- 0 441 594
- US-A- 4 667 092
- PATENT ABSTRACTS OF JAPAN vol. 11, no. 41 (E-478)(2488), 6 February 1987; & JP - A - 61208276
- PATENT ABSTRACTS OF JAPAN vol. 9, n0. 181 (E-331)(1904), 26 July 1985; & JP - A - 60053073
- EXTENDED ABSTRACTS vol. 86-1, no. 1, May 1986, page 407, abstract no. 276, Pennington, New Jersey, US; A.K. WEISS et al.: "Microlenticular Arrays for Solid-State Imagers"

## Description

### BACKGROUND OF THE INVENTION

### Field of the Invention

The present invention relates to a solid-state imaging device furnished with a filter having a microlens, and a method of manufacturing the same.

### Prior Art

As the method of fabricating a color solid-state imaging device, recently, methods of forming a color filter directly on the substrate on which the solid-state imaging device is formed are in the mainstream. Furthermore, with the purpose of enhancing the sensitivity of the solid-state imaging device itself, in order to focus light on each light sensing part, a microlens is formed on the color filter layer at the position corresponding to each light sensing part. It is formed by using a negative type material made of protein material such as gelatin and casein provided with photosensitive property, or recently a synthetic material possessing a property of forming a lens shape by melt-flow with heat.

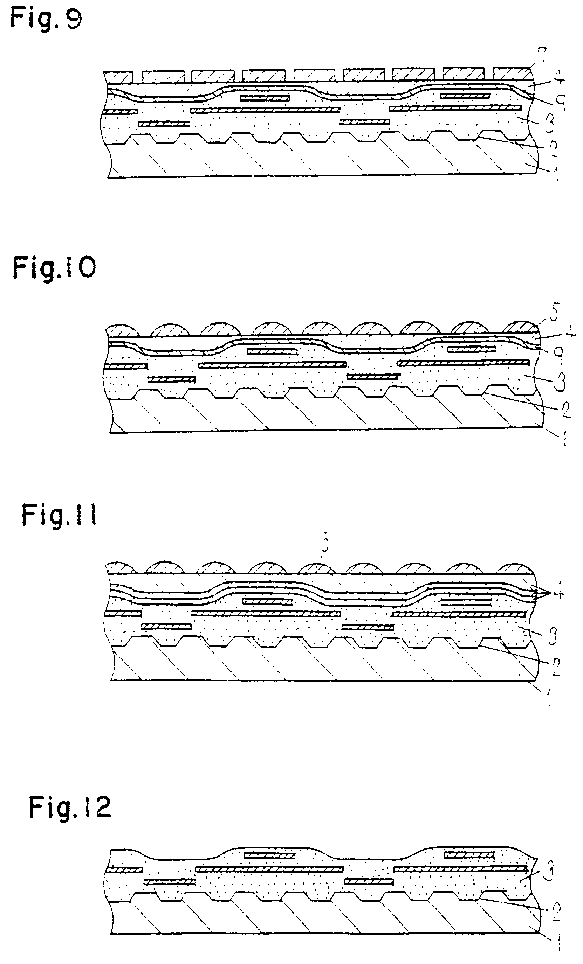

The conventional solid-state imaging device and its manufacturing method are described herein while referring to drawings. Fig. 11 is a partial cross section showing the structure of a conventional solid-state imaging device. Figs. 12 to 16 are partial cross sections showing the manufacturing method of the conventional solid-state imaging device in the sequence of processes.

First, the structure of the solid-state imaging device with a color filter having microlens in the prior art is explained while referring to Fig. 11.

A color filter layer 3 is formed on a solid-state imaging device substrate 1 at a position corresponding to each light sensing part 2 for receiving an incident light. The surface asperities on the color filter layer 3 are smoothed by a transparent material layers 4. On the smoothed surface of the uppermost transparent material layer 4, plural microlenses 5 are formed corresponding to each light sensing part 2, so that the incident light may be focused into each light sensing part 2.

Its operation is as follows.

The light entering the microlenses 5 is focused by the lens effect of the microlens 5. The focused light passes through the color filter layer 3, and is separated into colors to enter respective light sensing parts 2, thereby operating as the solid-state imaging device for obtaining a color pictorial image. In such a structure and an operation, the solid-state imaging device with a color filter having microlens is realized.

In Figs. 12 to 16, the manufacturing method of the conventional solid-state imaging device is described.

Fig.12 shows the state of forming the color filter layer 3 corresponding to each light sensing part 2 of the solid-state imaging device 1. In Fig. 13, a transparent material layer 4 is applied plural times (three times in this example), and the surface asperities of the color filter layer 3 are smoothed. In succession, in Fig. 14, a photosensitive material layer 6 is formed above the color filter layer 3 of which surface has been smoothed by the transparent material layer 4. In Fig. 15, consequently, the photosensitive material layer 6 is processed by selective exposure by means of a mask (not shown) and development, thereby forming a photosensitive material patterns 7. Finally, in Fig. 16, by heating and melting the photosensitive material patterns 7, a microlens 5 is formed. Thus, the solid-state imaging device with a color filter having microlens is realized.

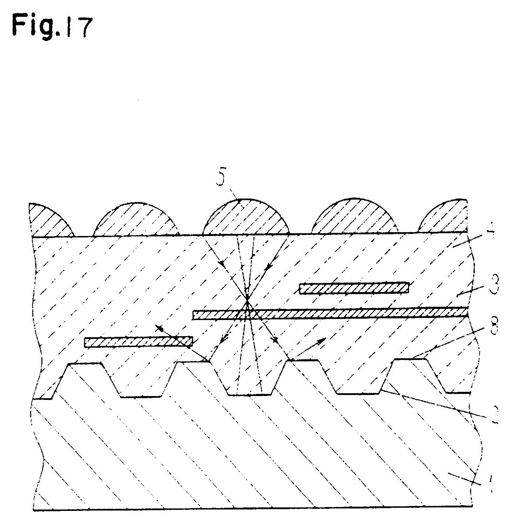

In such a conventional constitution, however, the color filter surface asperities are smoothed by forming the transparent material layer plural times, and the microlens layer is formed thereon. Therefore, the distance between the microlens and the light sensing parts is long, and the light sensitivity of the solid-state imaging device deteriorates. This mechanism is closely described below while referring to the drawing. Fig. 17 is a partial magnified cross section showing the mechanism of focus deviation of the solid-state imaging device in the prior art.

The color filter layer 3 is formed on the light sensing parts 2 and charge transfer parts 8 of the substrate 1. The surface asperities of the color filter layer 3 are smoothed by forming the transparent material layer 4 plural times. Further on it, the microlenses 5 are formed corresponding to each light sensing part 2. In this case, due to the thickness of the transparent material layer 4 for smoothing the surface asperities of the color filter layer 3, the distance from the microlenses 5 to the light sensing parts 2 becomes long, and the focal length is deviated. When the focal length is deviated, the light focused by the microlens 5 loses its focusing property and scatters, and the quantity of incident light to the light sensing parts 2 decreases. As a result, the light sensitivity of the solid-state imaging device is lowered, and the light sensitivity on the image characteristic also becomes poor. If attempted to form a microlens adjusted to the focal length, as the focal length becomes longer, the radius of curvature of the microlens becomes larger, and it means there is no other choice than to form a microlens low in the focusing density. Henceforth, however, as the solid-state imaging device is further downsized, and accordingly, the size of microlens must be shrinked, the light sensitivity becomes poorer. It is hence indispensable to raise the focusing density by efficiently focusing the incident light into the light sensing parts 2 by the lens effect of the microlens. Besides, as shown in Fig. 17, when the incident light enters the light sensing parts 2 largely off the focus, the incident light scatters, and a part of the light hits against the charge transfer part 8 existing between the light sensing parts 2, and is reflected to enter a neighboring light sensing part 2 other than the intended-one. In the neighboring light sensing part 2, since other color signal enters, if such reflection from the charge transfer part 8 increases, it leads to a mixture of colors on the color pictorial image characteristic, which is a major fault.

Concerning the manufacturing method, on the other hand, although the surface asperities of the color filter layer 3 are smoothed by forming the transparent material layer 4 plural times, the transparent material layer 4 is formed only by applying a transparent resin or the like, and it is impossible to flatten by application alone, which is another problem. It may be possible to flatten by increasing the thickness of the coat film or applying four times or five times, but it further causes to extend the distance between the light sensing parts 2 and the microlenses 5, which results in, needless to say, lowering of light sensitivity due to deviation of the focus as shown in Fig. 17. Meanwhile, the step of flattening the color filter layer surface before forming the microlens is indispensable. That is, if the microlenses are formed without flattening the color filter layer surface, uniform microlenses cannot be formed. With the microlenses of nonuniform shape, the light sensitivity fluctuates, which leads to a different problem of uneven sensitivity in an image characteristic.

It is hence a primary object of the invention to present a solid-state imaging device having microlenses for focusing the light entering the solid-state imaging device efficiently into the light sensing parts, and a method of manufacturing the same, in order to solve the above-discussed problems in the prior art.

### SUMMARY OF THE INVENTION

The invention relates to a constitution which comprises, in order to achieve the above object, an etching resistant material layer formed on a filter layer on a solid-state imaging device substrate, a transparent material layer with a flat surface and in a thin film formed on the etching resistant material layer, and microlenses having a hemisphere or nearly hemisphere shape formed on the transparent material layer.

A manufacturing method of the invention comprises a step of forming an etching resistant material layer on a filter layer formed on a solid-state imaging device substrate, a step of forming a transparent material layer by applying a transparent material on the etching resistant material layer, a step of etching back the transparent material layer, and a step of forming microlenses having a hemisphere or nearly hemisphere shape on the transparent material layer after the etching process.

By the constitution of the solid-state imaging device of the invention, the surface asperities of the filter layer are planarizated by the thin film of transparent resin, and in this state the uniform microlenses are formed, so that the distance between the light sensing parts and microlenses is not increased, and the deviation of focus is restrained. As a result, the focusing efficiency of incident light into the light sensing parts is improved, and lowering of light sensitivity is eliminated.

By the manufacturing method of the solid-state imaging device of the invention, moreover, by placing the intervening etching resistant material laver on the filter layer, the transparent material layer is later formed to flatten the surface to an extremely flat state. It is intended to reduce the thickness of the transparent resin laver by etching while maintaining the flat state, and therefore the filter surface is planarizated in a thin film, so that uniform microlenses can be formed without increasing the distance between the light sensing parts and microlenses. Besides, by the presence of the etching resistant material layer, even if the transparent material layer is overetched, the damage of the filter laver may be prevented.

### BRIEF DESCRIPTION OF THE DRAWINGS

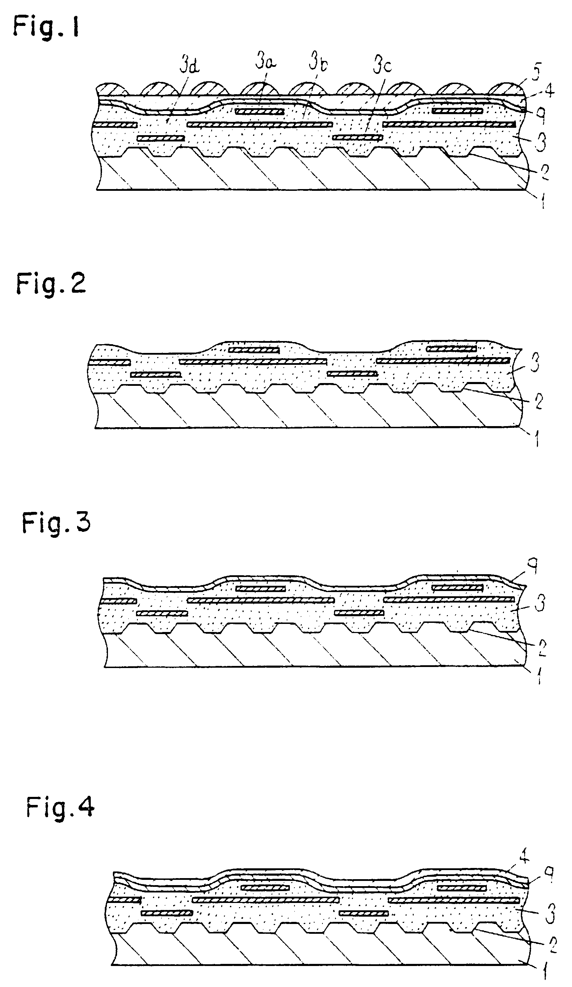

Fig. 1 is a partial cross section showing the constitution of a solid-state imaging device in an embodiment of the invention;
Fig. 2 is a partial cross section showing a first step of the manufacturing method of solid-state imaging device in the embodiment of the invention;
Fig. 3 is a partial cross section showing a second step of the manufacturing method of solid-state imaging device in the embodiment of the invention;
Fig. 4 is a partial cross section showing a third step of the manufacturing method of solid-state imaging device in the embodiment of the Invention;

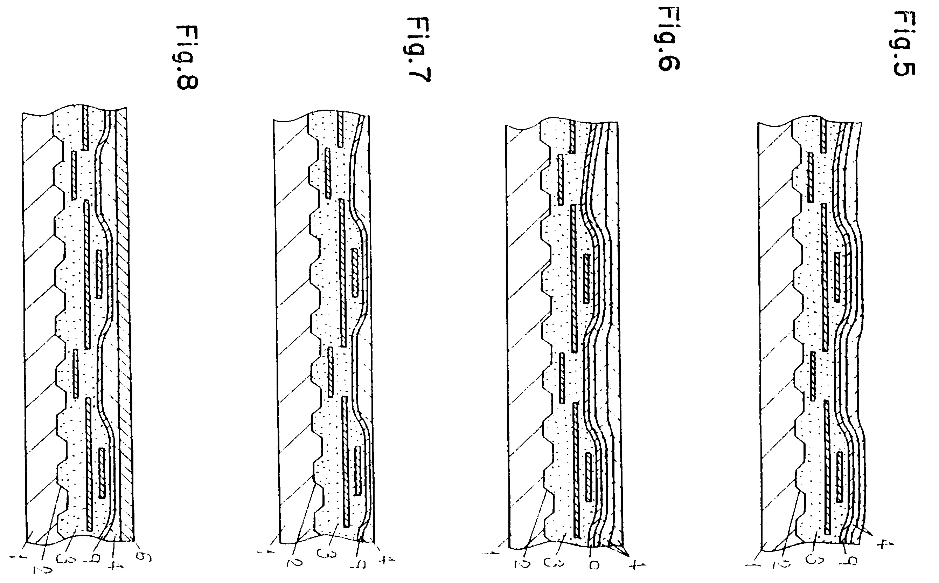

Fig. 5 is a partial cross section showing a fourth step of the manufacturing method of solid-state imaging device in the embodiment of the invention;
Fig. 6 is a partial cross section showing a fifth step of the manufacturing method of solid-state imaging device in the embodiment of the invention;
Fig. 7 is a partial cross section showing a sixth step of the manufacturing method of solid-state imaging device in the embodiment of the invention;
Fig. 8 is a partial cross section showing a seventh step of the manufacturing method of solid-state imaging device in the embodiment of the invention;
Fig. 9 is a partial cross section showing a eighth step of the manufacturing method of solid-state imaging device in the embodiment of the invention;
Fig. 10 is a partial cross section showing a ninth step of the manufacturing method of solid-state imaging device in the embodiment of the invention;
Fig. 11 is a partial cross section showing the constitution of a solid-state imaging device in the prior art;
Fig. 12 is a partial cross section showing a first step of the manufacturing method of solid-state imaging device in the prior art;

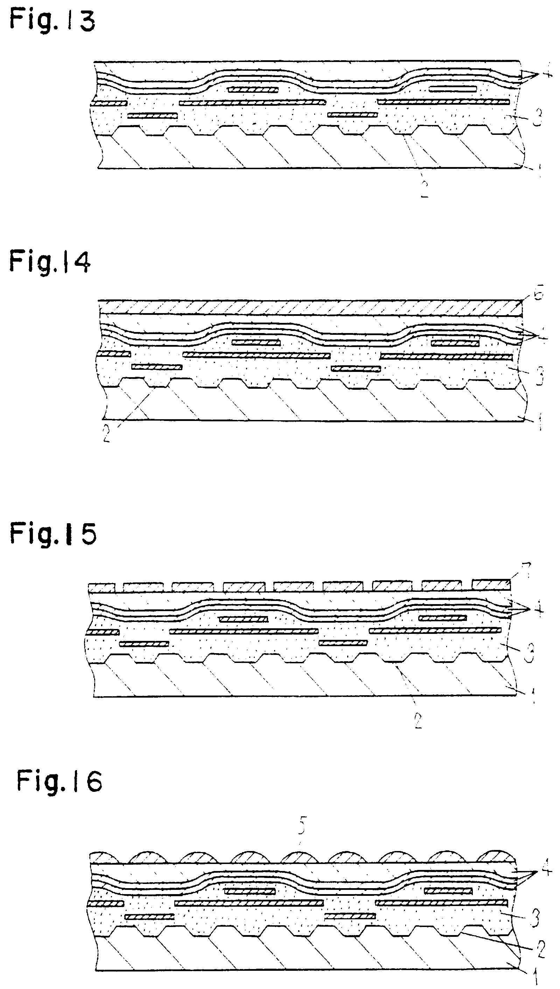

Fig. 13 is a partial cross section showing a second step of the manufacturing method of solid-state imaging device in the prior art;
Fig. 14 is a partial cross section showing a third step of the manufacturing method of solid-state imaging device in the prior art;
Fig. 15 is a partial cross section showing a fourth step of the manufacturing method of solid-state imaging device in the prior art;
Fig. 16 is a partial cross section showing a fifth step of the manuracturing method of solid-state imaging device in the prior art;
Fig. 17 is a partial magnified cross section showing the mechanism of focus deviation in the solid-state imaging device in the prior art.

### DETAILED DESCRIPTION OF THE INVENTION

Referring now to the drawings, an embodiment of the invention is described in detail below.

Fig. 1 is a partial cross section showing the constitution of solid-state imaging device in an embodiment of the invention. Figs. 2 to 10 are partial cross sections showing the manufacturing method of the solid-state imaging device in the embodiment in the sequence of steps.

First in Fig. 1, the constitution of the solid-state imaging device in the embodiment of the invention is explained.

A color filter layer 3 is formed on a solid-state imaging device substrate 1. The color filter aver 3 includes several kinds of color filters 3a - 3c positioned at predetermined areas of the transparent material 3d so that the color filters 3a - 3c correspond to the light sensing parts 2. The surface asperities of the color filter layer are planarizated by an etching resistant material layer 9 and a thin film transparent material layer 4. A plural microlenses 5 for focusing the incident light are formed on the transparent material layer 4. The shape of the microlens 5 is a semicircular or nearly semicircular form in the sectional direction. In other words, the microlens 5 has substantial hemisphere shape so as to realize an excellent focusing property and high lens effect. Since the transparent material layer 4 is a thin film, the distance between the light sensing parts 2 and the microlenses 5 is within the focal length, not having a long focal length such as to scatter again the light once focused due to deviation of the focus.

Its operation is explained below.

In this constitution, since the distance of the light receiving parts 2 and the microlenses 5 is within the focal length, the light entering the solid-state imaging device substrate 1 is focused by the microlenses 5, passes through the color filter layer 3, and is separated into colors, thereby entering in the intended light sensing parts 2 in a state of high focusing density. 3y the light entering in the state of high focusing density, the solid-state imaging device capable of obtaining a color pictorial image of a high light sensitivity realized.

Referring then to Figs. 2 to 10, the manufacturing method of the solid-state imaging device in the embodiment of the invention is explained below in the sequence of the steps.

Fig. 2 shows the state of forming the color filter layer 3 on the solid-state imaging device substrate 1. In Fig. 3, the etching resistant material layer 9 is formed on the color filter layer 3, and a protective layer is formed. In this case, the thickness must be as thin as to the extent not to sacrifice the etching resistance. Figs. 4 to 6 show the flattening steps, in which the transparent material layer 4 is applied three times in this embodiment. To flatten a step difference of about 1 µm by three applications, it is enough to flatten by a single coating thickness of about 1 µm. Fig. 6 shows the state of flattening of the surface asperities of the color filter layer 3 by the transparent material layer 4. Next, in Fig. 7, no transparent material 4 is uniformly etched on the whole surface by dry etching process such as O₂ ashing or wet etching by chemical solution. At this time, the etching amount is not required so much as to etch the transparent material 4 until reaching the etching resistant material layer 9 in the base layer, but etching is effected to such a thickness as to adjust the focus in the light sensing parts 2 depending on the film thickness of the microlenses to be formed, proper curvature and focal length. For this purpose, for example O₂ ashing is suited. Because O₂ ashing is easily capable of controlling the etching amount and etching uniformly the whole surface of the transparent mateiral 4. Next, in Fig. 8, the photosensitive material layer 6 is formed by the portion of the desired film thickness, and is baked at a temperature of about 110°C. In succession, in Fig. 9, the photosensitive material layer 6 is selectively exposed by using the mask (not shown), developed, and irradiated with ultraviolet rays to make the material transparent, thereby obtaining the photosensitive material layer pattern 7. In Fig. 10, succeedingly, by heating the photosensitive material laver pattern 7 at about 150°C, the photosensitive material layer pattern 7 is melted and fluidized to form microlenses 5.

Thus, in the solid-state imaging device and its manufacturing method according to the embodiment of the invention, the distance from the microlenses to the light sensing parts is shorter than in the prior art because the etching resistant material layer is formed on the filter layer formed on the solid-state imaging device substrate, the transparent material layer is formed thereon and this transparent material layer is reduced in thickness by etching to be a thin and flat film, and then microlenses are formed corresponding to the light sensing parts. As a result, even if microlenses of a smaller radius of curvature than the conventional microlenses are formed, the focus of the focused light may be adjusted to the light sensing parts, and the light of high focusing density enters the light sensing parts, so that the light sensitivity may be enhanced.

## Claims

1. A solid-state imaging device comprising an etching resistant material layer (9) formed on a filter layer (3) on a solid-state imaging device substrate (1), a thin-film transparent material layer (4) with a flat surface formed on the etching resistant material layer, and microlenses (5) of a substantial hemisphere shape formed on the transparent material layer.

2. A method of manufacturing solid-state imaging device comprising a step of forming an etching resistant layer (9) on a filter layer (3) formed on a solid-state imaging device substrate (1), a step of forming a transparent material layer (4) by applying a transparent material on the etching resistant material layer, a step of etching back the transparent material layer, and a step of forming microlenses (5) of a substantial hemisphere shape on the transparent material layer after the etching process.

## Patentansprüche

1. Eine Festkörper-Bildaufnahmeeinrichtung umfassend eine Schicht aus ätzbeständigem Material (9), die auf einer Filterschicht (3) auf dem Substrat (1) einer Festkörper-Bildaufnahmeeinrichtung gebildet ist, eine Schicht aus transparentem Material (4) als Dünnfilm mit einer flachen Oberfläche, die auf der Schicht aus ätzbeständigem Material gebildet ist, und Mikrolinsen (5) von im wesentlichen Halbkugelform, die auf der Schicht aus transparentem Material geformt sind.

2. Ein Verfahren zur Herstellung einer Festkörper-Bildaufnahmeeinrichtung, das einen Schritt umfaßt, eine ätzbeständige Schicht (9) auf einer Filterschicht (3) zu bilden, die auf dem Substrat (1) einer Festkörper-Bildaufnahmeeinrichtung gebildet ist, einen Schritt zum Formen einer Schicht aus transparentem Material (4), indem ein transparentes Material auf die Schicht aus ätzbeständigem Material aufgebracht wird, einen Schritt zum Zurückätzen der Schicht aus transparentem Material, und einen Schritt zum Bilden von Mikrolinsen (5) mit im wesentlichen Halbkugelform auf der transparenten Materialschicht nach dem Ätzvorgang.

## Revendications

1. Dispositif imageur à état solide, comprenant une couche de matière résistant à l'attaque chimique (9) formée sur une couche formant filtre (3) sur un substrat de dispositif imageur à état solide (1), une couche mince de matière transparente (4) avec une surface plane formée sur la couche de matière résistant à l'attaque chimique, et des microlentilles (5) de forme sensiblement hémisphérique formée sur la couche de matière transparente.

2. Procédé de fabrication d'un dispositif imageur à état solide, comprenant une étape consistant à former une couche résistant à l'attaque chimique (9) sur une couche formant filtre (3) formée sur un substrat de dispositif imageur à état solide (1), une étape consistant à former une couche de matière transparente (4) en appliquant une matière transparente sur la couche de matière résistant à l'attaque chimique, une étape consistant à attaquer chimiquement la couche de matière transparente, et une étape consistant à former des microlentilles de forme sensiblement hémisphérique sur la couche de matière transparente après le traitement d'attaque chimique.
